(19) Europäisches Patentamt
European Patent Office
Office européen des brevets

(11) **EP 4 439 369 A1**

(12) **EUROPEAN PATENT APPLICATION**
published in accordance with Art. 153(4) EPC

(43) Date of publication:
**02.10.2024 Bulletin 2024/40**

(51) International Patent Classification (IPC):
**G06F 30/00** (2020.01)

(21) Application number: 22894139.9

(86) International application number:
**PCT/CN2022/082665**

(22) Date of filing: **24.03.2022**

(87) International publication number:
**WO 2023/087593 (25.05.2023 Gazette 2023/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: 22.11.2021 CN 202111381751

(71) Applicant: **Tianjin Aerospace Reliability
Technology Co., Ltd.**
**Tianjin 300462 (CN)**

(72) Inventors:
• **MU, Haowen**
  **Tianjin 300462 (CN)**
• **LIU, Dejun**
  **Tianjin 300462 (CN)**
• **LIN, Dan**
  **Tianjin 300462 (CN)**
• **ZHAO, Wei**
  **Tianjin 300462 (CN)**
• **QIN, Xiaomeng**
  **Tianjin 300462 (CN)**

• **HU, Xin**
  **Tianjin 300462 (CN)**
• **GAO, Junchao**
  **Tianjin 300462 (CN)**
• **YU, Zhongling**
  **Tianjin 300462 (CN)**
• **LEI, Ting**
  **Tianjin 300462 (CN)**
• **HU, Dongliang**
  **Tianjin 300462 (CN)**
• **NING, Weiwei**
  **Tianjin 300462 (CN)**
• **YANG, Liwei**
  **Tianjin 300462 (CN)**
• **ZHANG, Xiaopeng**
  **Tianjin 300462 (CN)**
• **XU, Yuzhen**
  **Tianjin 300462 (CN)**
• **WAN, Chenghong**
  **Tianjin 300462 (CN)**

(74) Representative: **Scholl, Matthias**
**Friedrichstraße 114a**
**10117 Berlin (DE)**

(54) **METHOD FOR QUALITATIVE DESIGN FOR MAINTAINABILITY AT PRODUCT DESIGN STAGE**

(57) A method for maintainability qualitative design at a product design stage, comprising the steps of: establishing a maintainability design obstacle tree for a design target; carrying out qualitative analysis on the established maintainability design obstacle tree, and analyzing a minimal cut set and a minimal path set of the maintainability design obstacle tree to obtain a contradiction vector of the design target; obtaining a maintainability correction contradiction matrix according to a TRIZ contradiction matrix, determining a deterioration parameter and improvement parameters of the maintainability design contradiction matrix, and establishing a mapping relationship between an inventive principle set and a product design feature set; and obtaining TRIZ principle solution vectors by using the TRIZ-based maintainability correction contradiction matrix, obtaining a relational matrix of the design contradiction vector and the principle solution vectors by combining the obtained contradiction vector, and establishing a contradiction vector-principle solution vector relational equation of a corresponding contradiction design system, thereby facilitating design decision. Provided is a method for solving the problem of contradiction between maintainability design requirements and other quality design features.

EP 4 439 369 A1

**FIG. 4**

**Description**

The disclosure relates to the field of maintainability design, and more particularly to a qualitative design method for maintainability based on an obstacle tree and TRIZ theory at a product design stage.

Design quality is crucial for products, and obtaining high quality products with the least cost is the main pursuit of product designs. Product design quality is formed not only at the manufacturing stage, but also at the design stage and the after-sales service stage, and especially the design stage plays a decisive role. Maintainability is a quality characteristic of the product itself, which must be considered in the design stage. The process of integrating the maintainability demands into the product design and verifying the maintainability is known as maintainability design. Maintainability design is a very important item of the product design stage, which can improve the product quality to satisfy the needs of the users.

Conventional maintainability design guidelines set forth numerous maintainability-related design factors that need to be considered in the design of a product. However, there are two shortcomings in the actual maintainability design processes.

1) The design guidelines are mostly used for evaluation and assessment, which is a passive design manner. In the actual product design process, designers mainly focus on the realization of the product function, while ignoring the maintainability requirements. The current maintainability design work is achieved through carrying out maintainability tests on the physical prototype or virtual prototype of products and using the design guidelines to evaluate whether the product design meets the requirements of product maintainability. The design mode is passive, hysteretic and of low utility. Methodologically, the product design is contrary to the axiomatic design theory of the mapping from functional to structural domains. In some cases, maintainability deficiencies identified through maintainability tests are simply ignored because of the difficulty in making extensive changes to the design solution.

2) When maintainability requirements conflict with product functionality, no effective conflict resolution can be provided. In the process of product design, functional requirements are satisfied first. Currently, when there is a conflict between maintainability requirements and product functionality, due to the lack of effective conflict resolutions, designers generally prioritize the functionality of the requirements, and seldom, if ever, consider the maintainability requirements. The design guidelines, when guiding designers in product design, lack a clear and operable resolution method to solve the conflict between the maintainability requirements and functional requirements in product design.

Therefore, there is a need to study an optimal choice of design decisions for maintainability based on the feasible quantitative and qualitative design solutions.

The disclosure provides a method for preparing a qualitative design method for maintainability based on an obstacle tree and TRIZ theory at a product design stage.

In accordance with one embodiment of the disclosure, provided is a qualitative design method for maintainability based on an obstacle tree and TRIZ theory at a product design stage, the method comprising:

establishing a maintainability design obstacle tree for a design objective;

qualitatively analyzing the established maintainability design obstacle tree, analyzing a minimum cut set and a minimum path set of the maintainability design obstacle tree, to obtain a conflict vector of the design objective;

obtaining a revised maintainability conflict matrix based on a TRIZ conflict matrix, determining deterioration parameters and improvement parameters of the maintainability design conflict matrix, and establishing a mapping relationship between inventive principle sets and product design feature sets; and

obtaining a TRIZ principle solution vector based on the revised maintainability conflict matrix of TRIZ, in combination with the conflict vector, obtaining a relationship matrix between the conflict vector and the TRIZ principle solution vector, and establishing a relationship equation between the conflict vector- TRIZ principle solution vector of a conflicting design system, to help design decisions.

The qualitative design method for maintainability based on an obstacle tree and TRIZ theory at a product design stage of the disclosure can solve the conflict problem between maintainability design requirements and other quality design features: based on the minimum path set of the obstacle tree of the maintainability design problem, a relationship equation between the conflict vector of the corresponding conflict design system and the principle solution vector is established, which is conducive to design decisions.

FIG. 1 is a schematic diagram of a maintainability design obstacle tree according to one embodiment of the disclosure.

FIG. 2 is a schematic diagram of a determination process of a standardized inventive principle set according to one embodiment of the disclosure.

FIG. 3 is a basic structural diagram of a maintainability design obstacle tree corresponding to success trees according to one embodiment of the disclosure.

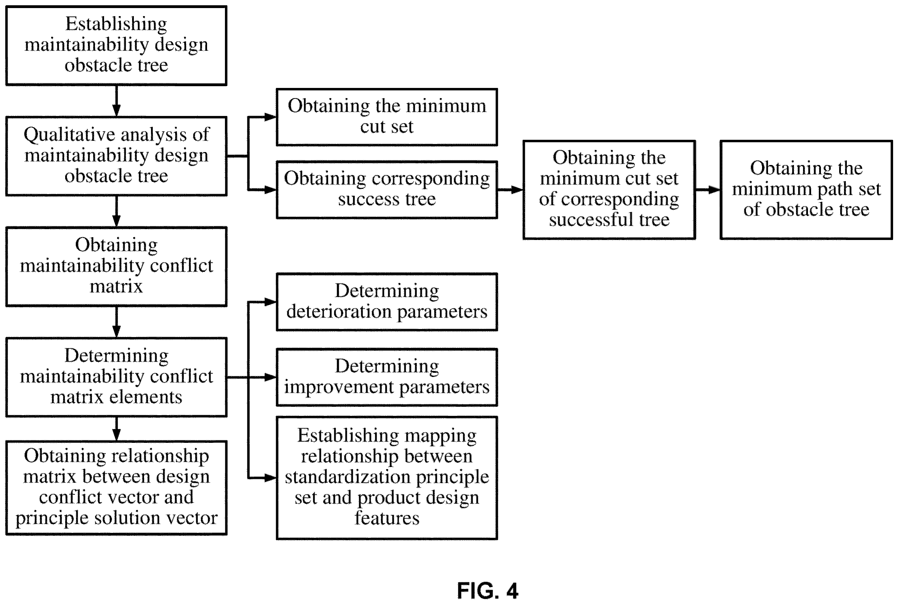

FIG. 4 is a flow chart of a qualitative design method for maintainability according to one embodiment of the disclosure.

To further illustrate the disclosure, embodiments detailing a method for preparing a qualitative design method for maintainability based on an obstacle tree and TRIZ theory at a product design stage are described below. It should be noted that the following embodiments are intended to describe and not to limit the disclosure.

The disclosure provides a qualitative design method for maintainability based on an obstacle tree and TRIZ theory at a product design stage, and the method comprises:

1). establishing a maintainability design obstacle tree for a design objective.

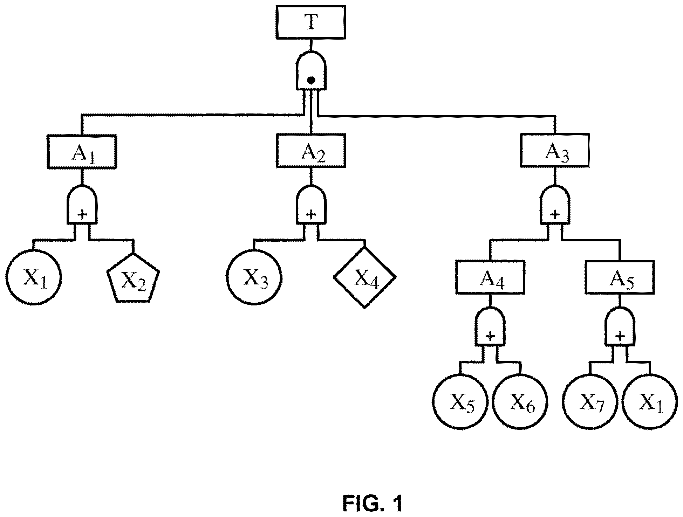

The maintainability design obstacle tree is a logical tree diagram, as shown in FIG. 1, which uses Boolean relationships to represent the occurrence process of maintainability design obstacles from results to causes, and the maintainability design obstacle tree graphically represents an interaction relationship between design obstacles and other events during maintainability design. In the maintainability design obstacle tree, an event is defined as a design strategy for a specific design feature of a product; a causal logic relationship exists between basic events or bottom events, which are connected to one or more top events through logical symbols comprising AND gates, OR gates, and NOT gates; the top events are an event that prevents understanding goals of the maintainability design from being achieved, labeled as T; the bottom events represents the most basic maintainability design obstacle, are most basic factors that trigger the occurrence of the top events, also called basic events or basic obstacle events, and are fundamental factors that constitute maintainability design conflicts.

In FIG. 1, $x_1$, $x_3$, $x_5$, $x_6$, $x_7$ are the basic events; $x_2$ and $x_4$ are normal events and events that do not need to be analyzed, respectively, and are treated as basic events; the events that are between the top events and the basic events are called intermediate events.

Specifically, during implementation, the first step is to confirm the top event T of the maintainability design obstacle tree, which is an event that prevents understanding of the maintainability design from being achieved; then, according to the order of causal logic, the precursor obstacle events of the top event are drawn. Through a series of logical symbols (including AND gate, OR gate, and NOT gate), one or more top events are decomposed downwards, and finally the bottom events of the most basic obstacle events are obtained. The bottom events $x_1$, $x_2$, $x_3$,... $x_n$ represent the most basic maintenance design obstacles and are the most basic factors that trigger the occurrence of the top events, also known as the basic events or basic obstacle events.

2) Qualitatively analyzing the established maintainability design obstacle tree in 1), analyzing a minimum cut set and a minimum path set of the maintainability design obstacle tree, to obtain a minimum path set vector or a conflict vector $P_j$ of the design objective:

The cut set refers to the combination of the basic events that appears simultaneously to cause the top event to occur, and is a collection of some bottom events in the obstacle tree. When these bottom events occur simultaneously, the top event is bound to occur. The minimum cut set refers to the combination of the minimum number of basic events that can cause the top events to occur, which indicates which basic events that appear simultaneously can cause the top events to occur. The minimum cut set represents the degree of influence of the selection of relevant design features in a maintainability design process on maintenance, and various possible influence paths, and characterizes the degree of influence of various possible occurrence paths of obstacle events on the obstacle events; the more the minimum number of cut set mentioned, the higher a probability of obstacles occurring. The smaller the number of basic events in the minimum cut set, the greater the impact on the design obstacles.

The solution method of the minimum cut set can refer to the solution method of the minimum cut set in the fault tree, which mainly includes the structural observation method, the matrix method, and the Boolean algebra simplification method.

The path set refers to a combination of basic events that can prevent the occurrence of top events. The minimum path set referred to is the combination of the minimum number of basic events that can prevent the top event from occurring. The minimum path set and minimum cut set have duality, indicating various paths and measures to eliminate maintenance design obstacles. The more the minimum path set, the more measures can be taken. It is usually easy to choose the minimum path set with fewer basic events to improve the measures.

The solution method for the minimum path set can refer to the solution method for the minimum path set in the fault tree, such as a success tree method.

The following describes a process of obtaining the minimum path set of a design goal using Boolean algebra simplification method.

For example, the minimum cut set of obstacle trees is found using Boolean algebra simplification method. As shown in FIG. 1, $T=A_1\times A_2\times A_3=(x_1+x_2)\times A_2\times A_3=(x_1 A_2+x_2 A_2)\times A_3=(x_1 x_3+ x_1 x_4+ x_2 x_3+ x_2 x_4)\times(A_4+ A_5)=(x_1 x_3+ x_1 x_4+ x_2 x_3+ x_2 x_4)\times(x_5+ x_6)+(x_1 x_3+ x_1 x_4+ x_2 x_3+ x_2 x_4)\times(x_7+ x_1)= x_1 x_3 x_5+ x_1 x_4 x_5+ _2 x_3 x_5+ x_2 x_4 x_5 +x_1 x_3 x_6+ x_1 x_4 x_6+ x_2 x_3 x_6+ x_2 x_4 x_6 +x_1 x_3 x_7+ x_1 x_4 x_7+ x_2 x_3 x_7+ x_2 x_4 x_7 +x_1 x_3 + x_1 x_4 + x_2 x_3 x_1+ x_2 x_4 x_1= x_1 x_3 + x_1 x_4+ x_2 x_3 x_5+ x_2 x_4 x_5 + x_2 x_3 x_6+ x_2 x_4 x_6 + x_2 x_3 x_7+ x_2 x_4 x_7$. In this way, the minimum cut set of the maintenance obstacle tree shown in FIG. 1 is $\{x_1, x_3\}$, $\{x_1, x_4\}$, $\{x_2, x_3, x_5\}$, $\{x_2, x_4, x_5\}$, $\{x_2, x_3, x_6\}$, $\{x_2, x_4, x_6\}$, $\{x_2, x_3, x_7\}$, $\{x_2, x_4, x_7\}$. The minimum cut set represents the degree of influence of the selection of relevant design features in a maintainability design process on maintenance, and various possible influence paths, and characterizes the degree of influence of various possible occurrence paths of obstacle events on the obstacle events.

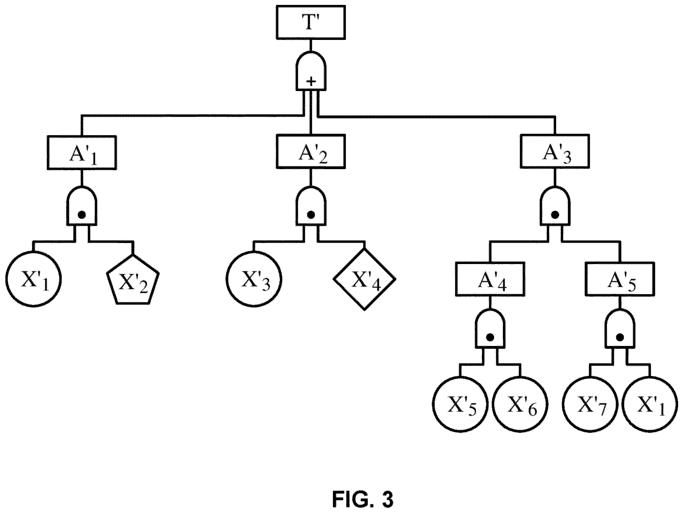

After obtaining the minimum cut set of the maintenance obstacle tree in FIG. 1, a corresponding success tree for the maintenance design obstacle tree is drawn. With FIG. 1 as an example, the corresponding success tree is shown in FIG. 3. The method to obtain the success tree is to turn the AND gate in the maintenance design obstacle tree into an OR gate, or the OR gate into an AND gate, so that the occurrence of various events changes nonoccurrence, and nonoccurrence changes occurrence. In FIG. 3, the events T', $A_1$', $x_1$'... respectively represent that events T, $A_1$, $x_1$... do not occur.

After obtaining the success tree, the minimum cut set of the event T' in the success tree is found through Boolean algebra simplification method. Taking the success tree shown in FIG. 3 as an example, $T'=A_1'+A_2'+A_3'=x_1' \times X_2'+x_3' \times X_4'+x_1' \times X_5' \times X_6' \times X_7'$, the minimum cut set of the success tree is transformed into the minimum path set of the maintenance design obstacle tree through a dual transformation. Therefore, the minimum path set of the maintenance design obstacle tree in FIG. 1 is $T = (x_1+x_2)\times(x_3+x_4)\times(x_1+x_5+x_6+x_7)$, that is, the minimum diameter set of the maintenance design obstacle tree is $\{x_1, x_2\}$, $\{x_3, x_4\}$, $\{x_1, x_5, x_6, x_7\}$; the minimum path set indicates various paths and measures to eliminate maintenance design obstacles in the product design process.

Assuming that the entire minimum path set of the maintenance design obstacle tree is $P_1$, $P_2$, ..., $P_j$, ..., $P_n$, among which, $P_j = (x_1, ... , x_i, ... , x_m)^T$, (i = 1,2, ..., m; j = 1,2, ... , n) is called the minimum path set vector or conflict vector, and m is a number of basic events contained in the j-th minimal path set $P_j$, and n is a number of the minimum path set.

3) Obtaining a revised maintainability conflict matrix based on a TRIZ conflict matrix, determining deterioration parameters and improvement parameters of the maintainability design conflict matrix, and establishing a mapping relationship between inventive principle sets and product design feature sets:

TRIZ is the acronym for Teoriya Resheniya Izobretatelshikh Zadatch in Russian, while in English it is the theory of innovative problem-solving.

TRIZ theory utilizes 40 inventive principles to solve technical conflicts in design. The TRIZ theory proposes using 39 universal feature parameters to describe technical conflicts.

In practical applications, the first step is to represent one or more sets of conflicts using 39 feature parameters, and with this method, the conflicts in actual design is transformed into general or standard technical conflicts.

The list of 39 feature parameters is shown in Table 1, and the 40 inventive principles are shown in Table 2.

Table 1

| No. | Feature parameters | No. | Feature parameters |
|---|---|---|---|
| 1 | Weight of a moving object | 21 | Power |
| 2 | Weight of a stationary object | 22 | Energy loss |
| 3 | Length of a moving object | 23 | Material Losses |
| 4 | Length of a stationary object | 24 | Information loss |
| 5 | Area of moving object | 25 | Loss of time |
| 6 | Area of a stationary object | 26 | Quantity of a substance or thing |
| 7 | Volume of a moving object | 27 | Reliability |
| 8 | Volume of a stationary object | 28 | Test accuracy |
| 9 | Velocity | 29 | Manufacturing accuracy |
| 10 | Force | 30 | Influence of external harmful factors on the object |

(continued)

| No. | Feature parameters | No. | Feature parameters |
|-----|--------------------|-----|--------------------|
| 11 | Stress or pressure | 31 | Hazardous factors generated by the object |
| 12 | Shape | 32 | Manufacturability |
| 13 | Stability of a structure | 33 | Operability |
| 14 | Strength | 34 | Maintainability |
| 15 | Action time of a moving object | 35 | Adaptability or versatility |
| 16 | Action time of a stationary object | 36 | Complexity of the device |
| 17 | Temperature | 37 | Difficulty of monitoring and testing |
| 18 | Light intensity | 38 | Degree of automation |
| 19 | Energy of a moving object | 39 | Production rate |
| 20 | Energy of a stationary object | | |

Table 2

| No. | Inventive principle | No. | Inventive principle |
|-----|---------------------|-----|---------------------|
| 1 | Split | 21 | Urgent Action |
| 2 | Take out | 22 | Turning Harm into Good |
| 3 | Local mass | 23 | Feedback |
| 4 | Symmetry change | 24 | Intermediaries |
| 5 | Merging | 25 | Self-service |
| 6 | Versatility | 26 | Reproduction |
| 7 | Sets | 27 | Low-cost, non-durable objects |
| 8 | Weight Compensation | 28 | Replacement of mechanical systems |
| 9 | Prior counteraction | 29 | Pneumatic or hydraulic structure |
| 10 | Pre-action | 30 | Flexible housings or membranes |
| 11 | Pre-compensation | 31 | Porous materials |
| 12 | Equipotentiality | 32 | Color change |
| 13 | Reversion | 33 | Homogeneity |
| 14 | Curvification | 34 | Disposal and repair |
| 15 | Dynamization | 35 | Parameter change |
| 16 | Failure or exceed action | 36 | Condition change |
| 17 | Dimensional change | 37 | Thermal expansion |
| 18 | Mechanical vibration | 38 | Accelerated oxidation |
| 19 | Periodic action | 39 | Inert environment |
| 20 | Continuity of effective action | 40 | Composites |

The TRIZ conflict matrix comprises 40 rows and 40 columns, where the first row represents the deteriorated feature parameters and the first column represents the improved feature parameters. Except for the first row and first column, the rest form a matrix, and the Nth matrix element represents the principle solution number corresponding to the deterioration feature and improvement feature.

The application method is as follows:

First, select a deterioration feature parameter number from the first row, and then select an improvement feature parameter number from the first column. The two numbers determine a specific matrix element at the intersection of the corresponding row and column, and the number given by the specific matrix element is the recommended inventive principle number.

The conflict matrix diagram is shown in Table 3:

Table 3

|  | No. 1 | No. 2 | No. 3 | ... | No. 39 |
|---|---|---|---|---|---|
| No. 1 |  |  | 15, 8, 29, 34 |  | 35, 3, 24, 37 |
| No. 2 |  |  |  |  | 1, 28, 15, 35 |
| ... |  |  |  |  |  |
| No. 39 | 3;a, 26, 24, 37 | 28, 27, 15, 3 | 18, 4, 28, 38 |  |  |

The revised maintainability conflict matrix obtained in 3) refers to a conflict matrix comprising seven parameters resulting from the decomposition of the 34th parameter among the 39 general engineering parameters described in Table 2 of TRIZ theory and the minimum path set obtained in 2).

The seven parameters comprise simplified maintenance operations, accessibility, standardization and interchangeability, error-proofing, difficulty of monitoring and testing, maintenance elements, and maintenance safety.

Table 4

| No. | Feature parameter | No. | Feature parameter |
|---|---|---|---|
| I | Simplified maintenance operations | VII | Difficulty of monitoring and testing |
| II | Accessibility | VI | Maintenance elements |
| III | Standardization and interchangeability | V | Maintenance safety |
| IV | Error-proofing |  |  |

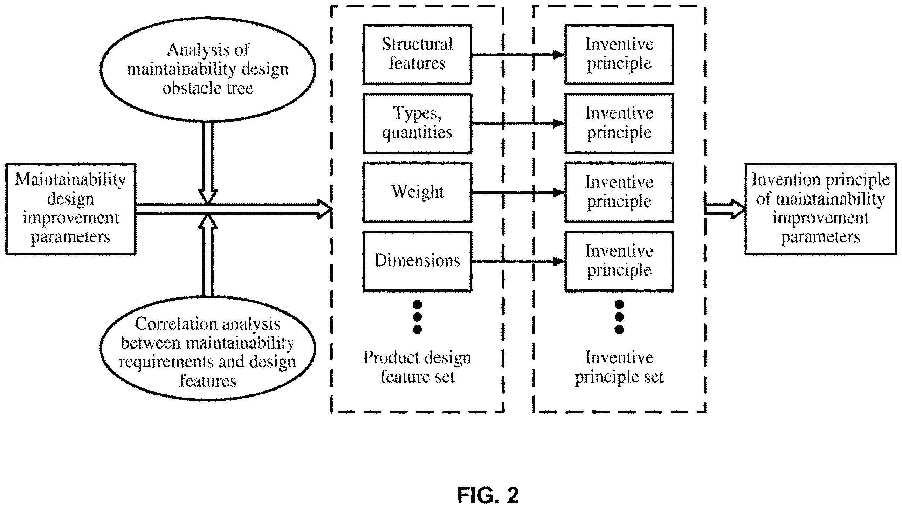

In 3), after establishing the mapping relationship between the standardized set of inventive principles and the product design feature set, the standardized inventive principles shown in Table 2 can correspond to the feature design of the product. The product design feature set refers to a series of parameterized representations of a product, such as structural features, types, quantities, dimensions, weight, layout, etc. As shown in FIG. 2, the inventive principle set is confirmed based on the product design feature set, that is, the mapping relationship between the inventive principle set and the product design feature set is established based on the product design feature set.

The improvement parameters refer to the 7 maintainability indicators decomposed from the general engineering parameter No. 34. The deterioration parameters refer to the minimum path sets obtained through the maintainability design obstacle tree in 2). Thus, the revised maintainability conflict matrix is an 8-row (n+1) column matrix with 7*n elements excluding the first row and the first column, comprising the improvement parameters associated with the 7 maintainability metrics and the deterioration parameters of the n minimum path set of the maintainability design obstacle tree.

The revised maintainability conflict matrix is shown in Table 5.

The first vertical column represents the improvement parameter of the conflict matrix, which are desired to be improved when solving the maintainability design problem. The first horizontal column represents the deterioration parameter of the maintenance conflict matrix, and the minimum path set of the maintenance design obstacle tree obtained in 2) is used as the deterioration parameter of the conflict matrix.

Table 5

|  | $\{x_1, x_2\}$ | $\{x_3, x_4\}$ | $\{x_1, x_5, x_6, x_7\}$ |
|---|---|---|---|
| No. 1 simplified maintenance operations |  |  |  |
| No. 2 accessibility |  |  |  |
| No. 3 standardization and interchangeability |  |  |  |
| No. 4 error-proofing |  |  |  |
| No. 5 difficulty of monitoring and testing |  |  |  |
| No. 6 maintenance elements |  |  |  |
| No. 7 maintenance safety |  |  |  |

After obtaining the above revised maintenance conflict matrix, the inventive principle set is confirmed based on the product design feature set. Specifically, after confirming the improvement parameters of the maintenance design, the correlation between maintenance design requirements and product design features is analyzed, and the minimum path set obtained from the analysis of the maintenance design obstacle tree is used to find the corresponding product design features. Then, the design feature requirements are paired with the deterioration parameters to look for the corresponding standardized inventive principles shown in Table 2 to obtain the inventive principles for improving the maintenance design parameters.

As shown in FIG. 2, the inventive principle sets are determined as follows:

First, each element in the minimum path set of the maintenance design obstacle tree is the minimum product design feature that needs to be improved to complete the confirmation of the top event. Therefore, the elements in each minimum path set obtained from the analysis of the maintenance design obstacle tree will be corresponded and transformed one-to-one with the 39 general features in TRIZ theory. Since the elements in the minimum path set are all design features, they can easily be corresponded to various common features. For example, the diameter of a screw corresponds to the number 4 (length of a stationary object) in the general engineering parameters.

Second, search for the TRIZ conflict resolution matrix, with the vertical coordinate being the No 34 maintainability and the horizontal coordinate being the generic features corresponding to each element in each minimum path set in the previous step. The inventive principle at the intersection point is filled in the corrected maintainability conflict matrix.

Third, based on the design characteristics of the product, the inventive principle is concretized into implementable design or improvement methods. According to the inventive principle No. 6: versatility, the corresponding implementable design method can consider the universality of screw diameter. Understandably, the seven characteristic parameters decomposed from maintainability may vary due to design task requirements, product characteristics, and the corresponding design costs and difficulties of each minimum diameter set, so that the adopted minimum diameter set, inventive principles, and implementable design methods may be different.

4). Obtaining a TRIZ principle solution vector $Y_j$ based on the revised maintainability conflict matrix of TRIZ, in combination with the minimum path set vector or conflict vector obtained in 2), obtaining a relationship matrix $C_{7 \times m}$ between the conflict vector and the TRIZ principle solution vector.

The TRIZ principle solution vector $Y_j$ is a collection of TRIZ principle set.

Let X be a standard set of conflict vectors, $X = \{x_1, x_2, \dots, x_n\}$, where each element $x_i (i \leq n)$ represents a conflict vector comprising a pair of extended engineering parameters.

Let Y be a collection of TRIZ principle solution vector set, $Y = \{y_1, y_2, \dots, y_n\}$, where each element $y_i (i \leq n)$ represents a principle solution subset corresponding to $x_i (i \leq n)$, in combination with the minimum path set vector obtained in 2), obtaining a relationship matrix $C_{7 \times m}$ between the conflict vector and the TRIZ principle solution vector.

The minimum path set vector or conflict vector is $P_j = (x_1, \dots, x_i, \dots, x_m)^T$, $(i = 1,2, \dots, m; j = 1,2, \dots, n)$.

Assuming that all of the basic event elements in $P_j$ constitute a maintenance design conflict, and given that there is a causal relationship between the design conflict and the principle solution, a relationship equation between the conflict vector of a given maintenance design obstacle and the principle solution vector is as follows:

$$Y_j = C_{7 \times m} P_j;$$

$Y_j = (y_1, y_2, \dots, y_m)^T$ represents the principle solution vector;
$C_{7 \times m}$ is a relation matrix between the conflict vector and the principle solution vector;

$$C_{7 \times m} = \begin{bmatrix} c_{11} & \cdots & c_{1m} \\ \vdots & \ddots & \vdots \\ c_{71} & \cdots & c_{7m} \end{bmatrix};$$

$c_{ij} = \begin{cases} 1 \\ 0 \end{cases}, i \leq 7, j \leq m$ represents a mapping between the conflict vector and the principle solution vector for maintainability design; 1 indicates that the maintenance conflict has a solution, and 0 indicates that the maintenance conflict has no solution.

Based on the actual product design, 40 standardized inventive principles in Table 2 are filled in the obtained revised maintainability conflict matrix (shown in Table 5). Thereafter, if there is a solution to the maintainability conflict, the corresponding element $c_{ij}$ in the relationship matrix is 0, and on the contrary, there is no solution to the maintainability conflict.

According to the mapping relationship between the product design feature set and the standardized inventive principle set shown in FIG. 2, the corresponding design features in the product design feature set is obtained; by improving these design features, the maintenance conflicts in the revised maintenance conflict matrix can be effectively resolved, thus completing the qualitative maintainability design for the maintenance obstacle event.

With regard to all maintenance design obstacles in the entire design system, assuming that the number of design obstacles (top event) is q, q obstacle trees are established and correspondingly q conflicts are present; at this point, the relationship equation between the conflict vector- principle solution vector of the conflicting design system is as follows:

$$Y = C \cdot P$$

$Y = (Y_1, Y_2, ... , Y_q)^T$ is a principle solution vector set;

$P = (P_1, P_2, ..., P_q)^T$ is a conflict vector set;

C is a relation matrix between the conflict vector and the principle solution vector of the conflicting design system.

The qualitative design method for maintainability based on an obstacle tree and TRIZ theory at a product design stage of the disclosure can provide an approach for designers to solve the conflict problem between maintainability design requirements and other quality design features: based on the minimum path set of the obstacle tree of the maintainability design problem, the relationship equation between the conflict vector of the corresponding conflict design system and the principle solution vector is established, which is conducive to assisting the designers in design decisions.

It will be obvious to those skilled in the art that changes and modifications may be made, and therefore, the aim in the appended claims is to cover all such changes and modifications.

**Claims**

1. A qualitative design method for maintainability at a product design stage, the method comprising:

   establishing a maintainability design obstacle tree for a design objective;
   qualitatively analyzing the established maintainability design obstacle tree, analyzing a minimum cut set and a minimum path set of the maintainability design obstacle tree, to obtain a conflict vector of the design objective;
   obtaining a revised maintainability conflict matrix based on a TRIZ conflict matrix, determining deterioration parameters and improvement parameters of the maintainability design conflict matrix, and establishing a mapping relationship between inventive principle sets and product design feature sets; and
   obtaining a TRIZ principle solution vector based on the revised maintainability conflict matrix of TRIZ, in combination with the conflict vector, obtaining a relationship matrix between the conflict vector and the TRIZ principle solution vector, and establishing a relationship equation between the conflict vector- TRIZ principle solution vector of a conflicting design system, to help design decisions.

2. The method of claim 1, **characterized in that** 40 inventive principles of TRIZ theory are filled in the maintainability design conflict matrix, if a corresponding element in the relationship matrix is 0, it means that there is a solution to a maintainability conflict, and on the contrary, there is no solution.

3. The method of claim 2, **characterized in that** the maintainability design obstacle tree is a logical tree diagram that uses Boolean relationships to represent an occurrence process of maintainability design obstacles from results to causes, and graphically represents an interaction relationship between design obstacles and other events during maintainability design; in the maintainability design obstacle tree, an event is defined as a design strategy for a specific design feature of a product; a causal logic relationship exists between basic events, and the basic events are connected to one or more top events through logical symbols comprising AND gates, OR gates, and NOT gates; the top events are an event that prevents understanding goals of the maintainability design from being achieved; the basic events represents a most basic maintainability design obstacle, are most basic factors that trigger the occurrence of the top events, and are fundamental factors that constitute maintainability design conflicts; and an event between the top events and the basic events is called an intermediate event.

4. The method of claim 3, **characterized in that** the minimum cut set refers to a combination of a minimum number of basic events causing the top events to occur; the minimum cut set indicates which basic events that appear simultaneously can cause the top events to occur, represents a degree of influence of the selection of relevant design features in a maintainability design process on maintenance, and various possible influence paths, and characterizes a degree of influence of various possible occurrence paths of obstacle events on the obstacle events; the more the minimum number of cut set mentioned, the higher a probability of obstacles occurring;

> the minimum path set refers to a combination of a minimum number of basic events that prevent the occurrence of the top events;
> the minimum path set indicates various paths and measures to eliminate maintainability design obstacles, and the more the minimum path set, the more measures are available; and
> the minimum path set and the minimum cut set have duality.

5. The method of claim 4, **characterized in that** the revised maintainability conflict matrix comprises improvement parameters and deterioration parameters; the minimum path set function as the deterioration parameters; the improvement parameters are seven parameters resulting from the decomposition of a maintainability of a parameter No. 34 of 39 generic engineering parameters in TRIZ theory;

> the seven parameters comprise simplified maintenance operations, accessibility, standardization and interchangeability, error-proofing, difficulty of monitoring and testing, maintenance elements, and maintenance safety; and
> a first vertical column in the revised maintainability conflict matrix represents the improvement parameters of the conflict matrix, which are desired to be improved when solving maintainability design problems; a first horizontal column in the revised maintainability conflict matrix represents the deterioration parameters of the maintainability conflict matrix, and the minimum path set of the maintainability design obstacle tree is used as the deterioration parameters of the conflict matrix.

6. The method of claim 5, **characterized in that** the inventive principle sets are determined as follows:
based on the improvement parameters of maintainability design, through a correlation analysis between the maintenance requirement and the design feature, analyzing the maintainability design obstacle tree to obtain the minimum cut set, finding corresponding product design features in the product design feature sets, matching the product design features with the deterioration parameters, finding corresponding standardized inventive principle in the inventive principle sets, and obtaining the maintainability parameter inventive principle.

7. The method of claim 6, **characterized in that** the relationship equation between the conflict vector- principle solution vector of a conflicting design system is as follows:

$$Y_j = C_{7 \times m} P_j;$$

$Y_j = (y_1, y_2, \ldots, y_m)^T$ represents the principle solution vector; $C_{7 \times m}$ is a relation matrix between the conflict vector and the principle solution vector; the conflict vector is $P_j = (x_1, \ldots, x_i, \ldots, x_m)^T$, i = 1,2, ... , m; j = 1,2, ..., n, m is a number of basic events contained in the j-th minimal path set $P_j$, and n is a number of the minimum path set;

$$C_{7 \times m} = \begin{bmatrix} c_{11} & \cdots & c_{1m} \\ \vdots & \ddots & \vdots \\ c_{71} & \cdots & c_{7m} \end{bmatrix};$$

$$c_{ij} = \begin{cases} 1 \\ 0 \end{cases}, i \leq 7, j \leq m$$

represents a mapping between the conflict vector and the principle solution vector for maintainability design; 1 indicates that the maintenance conflict has a solution, and 0 indicates that the maintenance conflict has no solution.

8. The method of claim 7, **characterized in that** when a number of design obstacles is q, q obstacle trees are established and correspondingly q conflicts are present; at this point, the relationship equation between the conflict vector- principle solution vector of the conflicting design system is as follows:

$$Y = C \cdot P$$

$Y = (Y_1, Y_2, \ldots, Y_q)^T$ is a principle solution vector set; $P = (P_1, P_2, \ldots, P_q)^T$ is a conflict vector set; and C is a relation matrix between the conflict vector and the principle solution vector of the conflicting design system.

FIG. 1

FIG. 2

**FIG. 3**

EP 4 439 369 A1

```
┌─────────────────────┐
│     Establishing    │
│ maintainability design │
│      obstacle tree  │
└─────────┬───────────┘
          │
          ▼
┌─────────────────────┐      ┌─────────────────────┐
│  Qualitative analysis of │──────▶│  Obtaining the minimum │
│  maintainability design │      │        cut set      │
│      obstacle tree  │      └─────────────────────┘
│                     │      ┌─────────────────────┐      ┌─────────────────────┐      ┌─────────────────────┐
│                     │──────▶│ Obtaining corresponding │─────▶│    Obtaining the    │────▶│    Obtaining the    │
└─────────┬───────────┘      │      success tree   │      │  minimum cut set    │      │  minimum path set   │
          │                  └─────────────────────┘      │  of corresponding   │      │  of obstacle tree   │
          ▼                                               │  successful tree    │      └─────────────────────┘
┌─────────────────────┐                                   └─────────────────────┘
│      Obtaining      │
│ maintainability conflict │
│        matrix       │      ┌─────────────────────┐
│                     │──────▶│     Determining     │
└─────────┬───────────┘      │ deterioration parameters │
          │                  └─────────────────────┘
          ▼
┌─────────────────────┐      ┌─────────────────────┐
│     Determining     │──────▶│     Determining     │
│ maintainability conflict │      │ improvement parameters │
│    matrix elements  │      └─────────────────────┘
│                     │
└─────────┬───────────┘      ┌─────────────────────┐
          │                  │ Establishing mapping │
          ▼                  │  relationship between │
┌─────────────────────┐      │ standardization principle │
│ Obtaining relationship │──▶│ set and product design │
│ matrix between design │      │       features      │
│   conflict vector and │      └─────────────────────┘
│ principle solution vector │
└─────────────────────┘
```

**FIG. 4**

## INTERNATIONAL SEARCH REPORT

| | International application No. |
|---|---|
| | **PCT/CN2022/082665** |

| A. CLASSIFICATION OF SUBJECT MATTER |
|---|
| G06F 30/00(2020.01)i |
| According to International Patent Classification (IPC) or to both national classification and IPC |

| B. FIELDS SEARCHED |
|---|
| Minimum documentation searched (classification system followed by classification symbols) |
| G06F |
| Documentation searched other than minimum documentation to the extent that such documents are included in the fields searched |
| Electronic data base consulted during the international search (name of data base and, where practicable, search terms used) |
| CNPAT, CNKI, WPI, EPODOC: 冲突, 矛盾, 问题, 逻辑, 障碍, 解决, 树, 分析, 矩阵, fault, tree, analysis, TRIZ, problem, FTA, matrix, DOT, contradiction+, conflict |

| C. DOCUMENTS CONSIDERED TO BE RELEVANT | | |
|---|---|---|
| Category* | Citation of document, with indication, where appropriate, of the relevant passages | Relevant to claim No. |
| PX | CN 113821845 A (TIANJIN AEROSPACE RELIABILITY TECHNOLOGY CO., LTD.) 21 December 2021 (2021-12-21) claims 1-8 | 1-8 |
| A | CN 106407512 A (SHANGHAI JIAO TONG UNIVERSITY) 15 February 2017 (2017-02-15) entire document | 1-8 |
| A | CN 106127408 A (GUIZHOU TRANSPORTATION PLANNING SURVEY & DESIGN ACADEME CO., LTD.) 16 November 2016 (2016-11-16) entire document | 1-8 |
| A | CN 103744972 A (SHANGHAI JIAO TONG UNIVERSITY) 23 April 2014 (2014-04-23) entire document | 1-8 |
| A | US 2008300946 A1 (INTERNATIONAL BUSINESS MACHINES CORPORATION) 04 December 2008 (2008-12-04) entire document | 1-8 |

☑ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **09 August 2022** | **18 August 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2022/082665**

**C.    DOCUMENTS CONSIDERED TO BE RELEVANT**

| Category* | Citation of document, with indication, where appropriate, of the relevant passages | Relevant to claim No. |
|---|---|---|
| A | 韦子辉 等 (WEI, Zihui et al.). "产品设计中多冲突问题解决过程研究 (Research on Multi-Contradictions Problem Solving in Product Design)" <br> 中国机械工程 (China Mechanical Engineering), <br> Vol. 21, No. 3, 10 February 2010 (2010-02-10), <br> ISSN: 1004-132X, <br> pages 263-265 | 1-8 |

Form PCT/ISA/210 (second sheet) (January 2015)

**INTERNATIONAL SEARCH REPORT**
Information on patent family members

International application No.

**PCT/CN2022/082665**

| Patent document cited in search report | | | Publication date (day/month/year) | Patent family member(s) | | | Publication date (day/month/year) |
|---|---|---|---|---|---|---|---|
| CN | 113821845 | A | 21 December 2021 | None | | | |
| CN | 106407512 | A | 15 February 2017 | None | | | |
| CN | 106127408 | A | 16 November 2016 | None | | | |
| CN | 103744972 | A | 23 April 2014 | None | | | |
| US | 2008300946 | A1 | 04 December 2008 | CN | 101315687 | A | 03 December 2008 |

Form PCT/ISA/210 (patent family annex) (January 2015)